# EUROPÄISCHE PATENTANMELDUNG

(11) **EP 2 975 419 A1**
(43) Veröffentlichungstag der Anmeldung: **20.01.2016**
(21) Anmeldenummer: 14177436.4
(22) Anmeldetag: 17.07.2014
(51) Int. Cl.: G01R 31/06, G01R 31/34

(54) **Verfahren zum Detektieren von Fehlstellen einer Wicklung**

(71) Anmelder: Siemens Aktiengesellschaft, 80333 München (DE)
(72) Erfinder: Ewert, Frank, 46499 Hamminkeln (DE); Mashkin, Andrey, 50672 Köln (DE); Staubach, Christian, 45768 Marl (DE)

(57) **Zusammenfassung**

Die Erfindung betrifft ein Verfahren zum Detektieren von Fehlstellen einer Wicklung (1) einer elektrischen Maschine, mit den Schritten: a) Einspeisen eines ersten Spannungspulses (2), bei dem zwischen einer Spannung U₀ und einer Spannung U₁ umgeschaltet wird, in ein erstes Ende (24) der Wicklung (1); b) Aufnehmen eines Referenzspannungsverlaufs (11), der den ersten Spannungspuls und den von Wicklung (1) zurückreflektierten ersten Spannungspuls aufweist, an dem ersten Ende (24) der Wicklung (1); c) Einspeisen eines zweiten Spannungspulses (2), bei dem zwischen der Spannung U₀ und der Spannung U₁ umgeschaltet wird, in das erste Ende (24) der Wicklung (1); d) Aufnehmen eines Spannungsverlaufs (12), der den zweiten Spannungspuls (2) und den von der Wicklung (1) zurückreflektierten zweiten Spannungspuls (2) aufweist, an dem ersten Ende (24) der Wicklung (1); e) Vergleichen des Spannungsverlaufs (12) mit dem Referenzspannungsverlauf (11).

## Beschreibung

Die Erfindung betrifft ein Verfahren zum Detektieren von Fehlstellen in einer Wicklung einer elektrischen Maschine.

Elektrische Maschinen, wie Generatoren oder Motoren, weisen einen Ständer und einen Läufer auf. Der Ständer weist dabei eine Mehrzahl an Ständerwicklungen elektrischer Leiter und der Läufer weist zur Erzeugung eines Magnetfelds entweder einen Permanentmagneten oder eine Läuferwicklung elektrischer Leiter auf. Eine Isolation ummantelt die elektrischen Leiter, um sie gegen benachbart angeordnete Windungen der Wicklungen, gegen die Umgebung und/oder gegen ein Blechpaket des Ständers elektrisch zu isolieren.

Fehlstellen in der Isolation des Läufers können zu Windungsschlüssen führen, also zu Kurzschlüssen zwischen benachbart angeordneten Windungen der Läuferwicklung. Diese Windungsschlüsse können zu einer thermischen Asymmetrie oder zu Verzerrungen des Magnetfelds führen, wobei die Asymmetrie und die Verzerrungen im Betrieb der elektrischen Maschine zu einer verstärkten Schwingungsbelastung der elektrischen Maschine führen. Herkömmliche Messverfahren zum Detektieren der Fehlstellen lassen sich unterscheiden in Messverfahren, die im Stillstand oder im Betrieb der elektrischen Maschine durchgeführt werden. Dabei treten manche Windungsschlüsse nur im Betrieb der elektrischen Maschine auf, so dass sie mit einem Messverfahren im Stillstand nicht detektierbar sind. Im Betrieb der elektrischen Maschine werden Windungsschlüsse mittels eines "Flux-Probe" Messverfahrens ermittelt, bei dem der magnetische Fluss an Orten zwischen dem Läufer um dem Ständer gemessen wird. Dieses Messverfahren ist jedoch aufwändig und resultiert in uneindeutigen Ergebnissen. Fehlstellen in der Isolation des Ständers können im Betrieb der elektrischen Maschine zu Teilentladungen führen, die die Isolation zersetzen. Dies kann im Extremfall zu einer vollständigen Zerstörung der Isolation führen, wodurch elektrische Durchschläge zwischen dem elektrischen Leiter und dem Blechpaket erfolgen können. Um Fehlstellen in der Isolation des Ständers möglichst frühzeitig zu detektieren, ist eine Überwachung des Herstellungsverfahrens der Isolation vonnöten. Bei dem Herstellungsverfahren werden die elektrischen Leiter von einem Glimmer aufweisenden Isolationsband umwickelt. In einem VPI-Prozess ("vacuum pressure impregnation") wird das Isolationsband unter Vakuum von einem Tränkharz durchtränkt und anschließend wird das Tränkharz unter Druckbeaufschlagung ausgehärtet. Wird der gesamte Ständer in einem einzigen Verfahren von dem Tränkharz durchtränkt und ausgehärtet, spricht man von einem GVPI-Prozess ("global vacuum pressure impregnation").

Herkömmlich werden Fehlstellen detektiert, in dem während des VPI-Prozesses die Kapazität und/oder der Verlustfaktor der Ständerwicklung gemessen werden. Damit sind jedoch nur integrale Messungen über die gesamte Ständerwicklung möglich. Eine Lokalisierung der Fehlstellen kann daher nicht erfolgen. Zudem können Fehlstellen mit kleinen räumlichen Erstreckungen nicht detektiert werden. Befinden sich beispielsweise Fehlstellen auf einer Länge von 1 m bei einer Wicklung, die 180 m lang ist, so können diese Fehlstellen nicht detektiert werden.

Aufgabe der Erfindung ist es, ein Verfahren zum Detektieren von Fehlstellen einer Wicklung einer elektrischen Maschine zu schaffen, bei der die Lokalisation der Fehlstellen einfach bewerkstelligbar ist.

Das erfindungsgemäße Verfahren zum Detektieren von Fehlstellen einer Wicklung einer elektrischen Maschine weist die Schritte auf: a) Einspeisen eines ersten Spannungspulses, bei dem zwischen einer Spannung U₀ und einer Spannung U₁ umgeschaltet wird, in ein erstes Ende der Wicklung; b) Aufnehmen eines Referenzspannungsverlaufs, der den ersten Spannungspuls und den von Wicklung zurückreflektierten ersten Spannungspuls aufweist, an dem ersten Ende der Wicklung; c) Einspeisen eines zweiten Spannungspulses, bei dem zwischen der Spannung U₀ und der Spannung U₁ umgeschaltet wird, in das erste Ende der Wicklung; d) Aufnehmen eines Spannungsverlaufs, der den zweiten Spannungspuls und den von der Wicklung zurückreflektierten zweiten Spannungspuls aufweist, an dem ersten Ende der Wicklung; e) Vergleichen des Spannungsverlaufs mit dem Referenzspannungsverlauf.

Beim Aufnehmen des Referenzspannungsverlaufs und des Spannungsverlaufs wird eine Überlagerung der in die Wicklung eingespeisten Pulse und der anschließend von der Wicklung zurückreflektierten Spannungspulse gemessen. Die charakteristische Form des Referenzspannungsverlaufs und des Spannungsverlaufs hängt von dem Verlauf des Wellenwiderstands entlang der Wicklung ab. Die Fehlstellen führen zu einer lokalen Änderung des Wellenwiderstands in der Wicklung. Dies ist beispielsweise der Fall, wenn sich lokal die Kapazität der Isolation aufgrund der Fehlstellen ändert oder wenn ein Windungsschluss vorliegt. Trifft der Spannungspuls auf die lokale Änderung des Wellenwiderstands, wird ein Teil des Spannungspulses von der Wicklung zurückreflektiert, was beim Aufnehmen des Spannungsverlaufs detektiert wird. Durch den Vergleich des Spannungsverlaufs mit dem Referenzspannungsverlaufs kann somit die Bildung einer Fehlstelle beobachtet werden.

Unter Heranziehen der Laufzeit, die der Spannungspuls benötigt, um von dem ersten Ende bis zu der Fehlstelle und wieder zurück bis zu dem ersten Ende zu gelangen, kann der Ort ermittelt werden, an dem die Fehlstelle angeordnet ist. Das Verfahren kann vorteilhaft Fehlstellen detektieren, die eine Erstreckung im Millimeterbereich haben. Zudem ist das Verfahren einfach durchführbar, da lediglich ein Oszilloskop zum Aufnehmen des Referenzspannungsverlaufs und des Spannungsverlaufs und ein Funktionsgenerator zum Erzeugen der Spannungspulse vorgesehen werden braucht.

Bevorzugt wird mit einer Steilheit von 0,1 V bis 100 V pro Nanosekunde oder mit einer Steilheit von -0,1 bis -100 V pro Nanosekunde die Spannung umgeschaltet. Es ist auch möglich, die Spannungspulse mit noch steileren Steilheiten zu verwenden. Die Genauigkeit, mit der Ort der Fehlstelle ermittelt werden kann, ist umso höher je steiler die Flanke der Spannungspulse ist, d.h. je schneller von der Spannung U₀ auf die Spannung U₁ umgeschaltet wird. Mit den angegebenen Wertebereichen kann der Ort der Fehlstelle mit einer hohen Genauigkeit bestimmt werden.

Die Wicklung ist bevorzugt eine Läuferwicklung und für den ersten Spannungspuls und/oder den zweiten Spannungspuls wird ein Umrichterimpuls einer die Läuferwicklung speisenden Erregereinrichtung eingesetzt. Damit braucht vorteilhaft für das Verfahren kein Funktionsgenerator eingesetzt werden und es lassen sich die Fehlstellen während des Betriebs der elektrischen Maschine detektieren. Bei einer dreipoligen elektrischen Maschine, die mit 50 Hz rotiert, kann somit alle 3,3 ms eine Messung vorgenommen werden, wodurch sich vorteilhaft Fehlstellen schnell detektieren lassen. Zudem kann vorteilhaft eine Mittelung der Spannungsverläufe vorgenommen werden, so dass die Spannungsverläufe mit einer hohen Genauigkeit aufgenommen werden können.

Es ist bevorzugt, dass der Referenzspannungsverlauf an der elektrischen Maschine zu einem Zeitpunkt durchgeführt wird, an dem die elektrische Maschine keine Fehlstellen aufweist. Der Referenzspannungsverlauf kann beispielsweise aufgenommen werden, wenn nach der Fertigstellung der elektrischen Maschine eine Hochspannungsprüfung durchgeführt wurde und bei der Hochspannungsprüfung keine Fehlstellen detektiert wurden. Somit lassen sich vorteilhaft aus dem Vergleich des Referenzspannungsverlaufs mit dem Spannungsverlauf die Fehlstellen detektieren.

Die Wicklung ist bevorzugt eine Ständerwicklung und das Verfahren wird während dem Herstellen der Isolation der Ständerwicklung durchgeführt. Es ist bevorzugt, dass das Verfahren mit den Schritten durchgeführt wird: f) Aufnehmen einer Mehrzahl an Referenzspannungsverläufen durch Wiederholen der Schritte a) und b) bei verschiedenen ersten Zeitpunkten während dem Herstellen der Isolation einer elektrischen Maschine ohne Fehlstellen; g) Aufnehmen einer Mehrzahl an Spannungsverläufen durch Wiederholen der Schritte c) und d) bei verschiedenen zweiten Zeitpunkten während dem Herstellen der Isolation einer anderen elektrischen Maschine, wobei die zweiten Zeitpunkte derart gewählt werden, dass sie dem Herstellungsfortschritt der ersten Zeitpunkte entsprechen; h) Wiederholen des Schritts e), wobei diejenigen Referenzspannungsverläufe und Spannungsverläufe miteinander verglichen werden, die bei dem Herstellungsfortschritt entsprechenden ersten und zweiten Zeitpunkten aufgenommen wurden. Hierbei können vorteilhaft Fehlstellen schon während dem Herstellen der Isolation detektiert werden und durch eine Änderung der Prozessparameter, wie beispielsweise Temperatur des Tränkharzes und/oder Druck während dem VPI- oder GVPI-Prozess, kann die Bildung der Fehlstellen unterbunden werden. Alternativ ist es aufgrund der Möglichkeit, den Ort der Fehlstelle zu bestimmen, möglich, die Fehlstellen nach dem Herstellen der Isolation und vor der Hochspannungsprüfung zu reparieren.

Bevorzugt weist das Verfahren den Schritt auf: g1) Aufnehmen bei jedem der zweiten Zeitpunkte an einem zweiten Ende der Läuferwicklung, das dem ersten Ende gegenüberliegend angeordnet ist, jeweils eines Transmissionsspannungsverlaufs, der den zweiten Spannungspuls aufweist. Aus der Laufzeit, die die Spannungspulse benötigen, um von dem ersten Ende zu dem zweiten Ende zu gelangen, und der Länge der Ständerwicklung lässt sich vorteilhaft die Ausbreitungsgeschwindigkeit der Spannungspulse ermitteln. Es ist bevorzugt, dass das Verfahren den Schritt aufweist: g2) Vergleichen jeder der Transmissionsspannungsverläufe mit dem frühesten Transmissionsspannungsverlauf. Die Ausbreitungsgeschwindigkeit hängt von dem Wellenwiderstand der Wicklung ab. Weil sich während dem Herstellen der Isolation die Kapazität der Wicklung ändert, ändert sich auch der Wellenwiderstand der Wicklung. Diese Änderung des Wellenwiderstands lässt sich durch den Vergleich der Transmissionsspannungsverläufe mit dem Referenztransmissionsspannungsverlauf verfolgen. Durch das Verfolgen der Änderung des Wellenwiderstands lässt sich vorteilhaft der Reaktionsfortschritt beim Herstellen der Isolation überwachen.

Bevorzugt weist das Verfahren die Schritte auf: i) Bestimmen einer Ausbreitungsgeschwindigkeit für mindestens einen der zweiten Spannungspulse aus dem entsprechenden Transmissionsspannungsverlauf und der Länge der Läuferwicklung; j) Bestimmen des Ortes einer Fehlstelle unter Heranziehen der Ausbreitungsgeschwindigkeit und des Vergleichs des Referenzspannungsverlaufs mit dem Spannungsverlauf.

Im Folgenden wird anhand der beigefügten schematischen Zeichnungen das erfindungsgemäße Verfahren näher erläutert. Es zeigen
- Figur 1: eine Vorrichtung zum Durchführen des Verfahrens,
- Figur 2: verschiedene mit dem Verfahren aufgenommene Spannungsverläufe und
- Figur 3: zwei Kapazitätsverläufe und ein Druckverlauf während dem Herstellen einer Isolation.

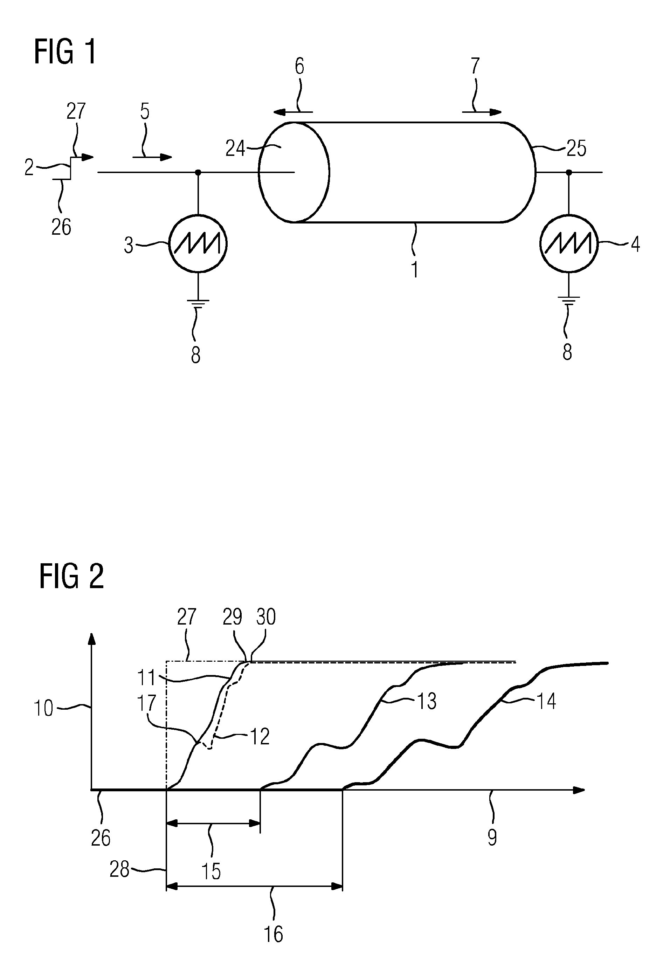

Figur 1 zeigt eine in einer elektrischen Maschine angeordnete Wicklung 1 aus einem elektrischen Leiter. Der Leiter ist von einer Isolation umhüllt (nicht in Figur 1 dargestellt), um den Leiter gegen benachbarte Windungen der Wicklung 1, gegen die Umgebung und/oder gegen ein Ständerblechpaket elektrisch zu isolieren. Die Wicklung 1 kann eine Läuferwicklung oder eine Ständerwicklung einer elektrischen Maschine sein. Die Wicklung 1 weist ein erstes Ende 24 und ein zweites Ende 25 auf, wobei das zweite Ende 25 dem ersten Ende 24 gegenüberliegend angeordnet ist. An dem ersten Ende 24 ist ein erstes Oszilloskop 3 und an dem zweiten Ende 25 ist ein zweites Oszilloskop 4 angeschlossen, wobei beide Oszilloskope 3, 4 jeweils an eine Erdung 8 angeschlossen sind. Mit dem ersten Oszilloskop 3 lässt sich an dem ersten Ende 24 und mit dem zweiten Oszilloskop 4 lässt sich an dem zweiten Ende 25 die an dem elektrischen Leiter anliegende Spannung zeitaufgelöst bestimmen. In dem Verfahren wird ein Spannungspuls 2 in das erste Ende 24 der Wicklung 1 eingespeist 5, wobei bei dem Spannungspuls 2 mit einer steilen Flanke zwischen einer Spannung U₀ 26 und einer Spannung U₁ 27 umgeschaltet wird. Die Spannung U₀ 26 ist verschieden von der Spannung U₁ 27, wobei gelten kann, dass U₁ > U₀ oder U₁ < U₀ ist. Der Spannungspuls 2 kann mit einem Funktionsgenerator erzeugt werden oder der Spannungspuls 2 ist ein Umrichterimpuls einer die Läuferwicklung speisenden Erregereinrichtung.

Ein Teil des eingespeisten Spannungspulses 5 wird von der Wicklung reflektiert 6, wohingegen ein anderer Teil des eingespeisten Spannungspulses 5 transmittiert 7 wird. Mit dem ersten Oszilloskop 3 wird die Überlagerung des eingespeisten Spannungspulses 3 und des reflektierten Spannungspulses 6 aufgenommen, wohingegen mit dem zweiten Oszilloskop 4 der transmittierte Spannungspuls 7 aufgenommen wird.

Figur 2 zeigt verschiedene mit den Oszilloskopen 3, 4 aufgenommen Spannungsverläufe in einer Auftragung, bei der über die Abszisse die Zeit 9 und über die Ordinate die Spannung 10 aufgetragen ist. Es wird ein erster Spannungspuls in die Läuferwicklung eingespeist und mit dem ersten Oszilloskop 3 ein Referenzspannungsspannungsverlauf 11 aufgenommen. Handelt es sich bei der Wicklung 1 um eine Läuferwicklung, so wird der Referenzspannungsspannungsverlauf 11 zu einem Zeitpunkt aufgenommen, an dem die Läuferwicklung keine Fehlstellen aufweist. Dies kann beispielsweise unmittelbar nach einer erfolgreichen Hochspannungsprüfung der elektrischen Maschine erfolgen. Zu einem späteren Zeitpunkt wird ein zweiter Spannungspuls in die Wicklung eingespeist und mit dem ersten Oszilloskop 3 ein Spannungsverlauf 12 aufgenommen. Durch einen Vergleich des Spannungsverlaufs 12 mit dem Referenzspannungsverlauf 11 können Fehlstellen in der Wicklung detektiert werden. Wie es aus Figur 1 ersichtlich ist, weisen der Referenzspannungsverlauf 11 und der Spannungsverlauf 12 zu frühen Zeiten die Spannung U₀ 26 auf, um an einem Zeitpunkt t₃ 28 anzusteigen. Der Referenzspannungsverlauf 11 erreicht an einem Zeitpunkt t₄ 29 die Spannung U₁ 27 und der Spannungsverlauf 12 erreicht an einem Zeitpunkt t₅ 30, der später als der Zeitpunkt t₄ 29 liegt, die Spannung U₁ 27. Die Spannung des Spannungspulses 2 wird dabei erst nach dem Zeitpunkt t₄ 29 wieder zu der Spannung U₀ 26 umgeschaltet. Der Referenzspannungsverlauf 11 und der Spannungsverlauf 12 sind identisch bis zu einem Zeitpunkt t₆ 17, ab dem der Spannungsverlauf 12 eine niedrigere Spannung als der Referenzspannungsverlauf 11 hat. Aus dem Zeitdifferenz t₆-t₃ und der Ausbreitungsgeschwindigkeit der Spannungspulse lässt sich der Ort einer Fehlstelle in der Wicklung bestimmen. Bei der Läuferwicklung wird zu verschiedenen Zeitpunkten der zweite Spannungspuls in das erste Ende 24 der Wicklung 1 eingespeist und ein Spannungsverlauf 12 aufgenommen. Der zeitliche Abstand der verschiedenen Zeitpunkte ist möglichst kurz, so dass eine Bildung von Fehlstellen zeitnah detektiert werden kann. Bei einer dreipoligen Maschine, die mit einer Frequenz von 50 Hz rotiert, sind dies beispielsweise 3,3 ms.

Handelt es sich bei der Wicklung um eine Ständerwicklung, wird ein Spannungspuls in jede Phase des Ständers eingespeist und es wird ein jeweils ein Oszilloskop 3, 4 an den Enden jeder Phase angeschlossen. Es wird ein Referenzspannungsverlauf 11 zu verschiedenen Zeitpunkten während der Herstellung der Isolation der Ständerwicklung aufgenommen. Die verschiedenen Zeitpunkte sind derart gewählt, dass sie derart verschiedene Herstellungsfortschritte abbilden, dass möglichst das vollständige Herstellungsverfahren abgedeckt wird. Die Referenzspannungsverlaufe 11 werden dabei bei einer elektrischen Maschine aufgenommen, bei deren Herstellungsverfahren keine Fehlstellen gebildet werden. Anschließend werden diejenigen Spannungsverläufe 12 und mit denjenigen Referenzspannungsverläufen 11 verglichen, die bei einem gleichen Herstellungsfortschritt aufgenommen sind.

Mit dem zweiten Oszilloskop 4 lässt sich die Laufzeit 15, 16 bestimmen, die ein Spannungspuls 2 benötigt, um von dem ersten Ende 24 zu dem zweiten Ende 25 zu gelangen. Figur 2 zeigt einen Transmissionsspannungsverlauf 13 am Beginn der Durchtränkung in dem VPI- bzw. GVPI-Prozess und einen Transmissionsspannungsverlauf 14 am Ende der Durchtränkung. Der Transmissionspannungsverlauf 13 unterscheidet sich vom Referenzspannungsverlauf 11 dadurch, dass die Spannung nach einer Laufzeit 15 ausgehend von der Spannung U₀ 26 ansteigt. Der Transmissionspannungsverlauf 14 unterscheidet sich vom Referenzspannungsverlauf 11 dadurch, dass die Spannung nach einer Laufzeit 16 ausgehend von der Spannung U₀ 26 ansteigt, wobei die Laufzeit 16 länger als die Laufzeit 15 ist.

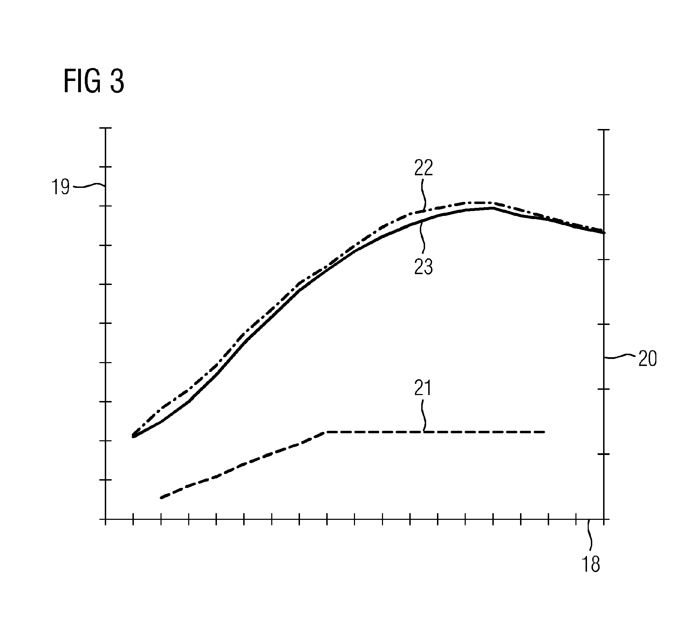

Figur 3 veranschaulicht den Herstellungsfortschritt in dem Herstellungsverfahren der Isolation mit einer Auftragung, bei der über die Abszisse die Zeit 18 und über der Ordinate die Kapazität 20 der Wicklung 1 und der Druck 19 des Tränkharzes aufgetragen sind. Figur 3 zeigt einen Referenzkapazitätsverlauf 22 und einen Kapazitätsverlauf 23. Bei dem Referenzkapazitätsverlauf 22 sind keine Fehlstellen gebildet worden, wohingegen beim Kapazitätsverlauf 23 Fehlstellen in Form von Lufteinschlüssen in der Isolation gebildet worden sind. Aufgrund der Lufteinschlüsse hat der Kapazitätsverlauf 23 eine geringere Kapazität als der Referenzkapazitätsverlauf 22. Die Kapazität des Referenzkapazitätsverlaufs 22 und des Kapazitätsverlaufs 23 steigen zunächst an, weil Luft durch das Tränkharz ersetzt wird. An einem gewissen Zeitpunkt fängt das Tränkharz an auszuhärten, wodurch die Kapazität des Tränkharzes absinkt. Es bildet sich somit jeweils ein Maximum in dem Referenzkapazitätsverlauf 22 und in dem Kapazitätsverlauf 23 aus. Ebenfalls ist in Figur 3 der zu den Kapazitätsverläufen 22, 23 zugehörige Druckverlauf 21 dargestellt.

Anhand von zwei Beispielen wird im Folgenden das erfindungsgemäße Verfahren näher erläutert.

In einem ersten Beispiel werden Fehlstellen einer Läuferwicklung 1 einer elektrischen Maschine mit den Schritten detektiert: a) Einspeisen eines ersten Spannungspulses 2 mittels eines Funktionsgenerators, wobei bei dem ersten Spannungspuls 2 schnell zwischen einer Spannung U₀ und einer Spannung U₁ umgeschaltet wird, in ein erstes Ende 24 der Wicklung 1 zu einem Zeitpunkt, an dem die Läuferwicklung keine Fehlstellen aufweist; b) Aufnehmen eines Referenzspannungsverlaufs 11, der den ersten Spannungspuls und den von Wicklung 1 zurückreflektierten ersten Spannungspuls aufweist, an dem ersten Ende 24 der Wicklung 1; c) Einspeisen eines zweiten Spannungspulses 2, wobei der zweite Spannungspuls ein Umrichterimpuls einer die Läuferwicklung speisenden Erregereinrichtung ist, wobei bei dem zweiten Spannungspuls schnell zwischen der Spannung U₀ und der Spannung U₁ umgeschaltet wird, in das erste Ende 24 der Wicklung 1; d) Aufnehmen eines Spannungsverlaufs 12, der den zweiten Spannungspuls 2 und den von der Wicklung 1 zurückreflektierten zweiten Spannungspuls 2 aufweist, an dem ersten Ende 24 der Wicklung 1; e) Vergleichen des Spannungsverlaufs 12 mit dem Referenzspannungsverlauf 11.

In einem zweiten Beispiel werden Fehlstellen einer Ständerwicklung 1 einer elektrischen Maschine während dem Herstellen der Isolation der Ständerwicklung mit den Schritten detektiert: a) Einspeisen eines ersten Spannungspulses 2, bei dem schnell zwischen einer Spannung U₀ und einer Spannung U₁ umgeschaltet wird, in ein erstes Ende 24 der Ständerwicklung 1, wobei die Ständerwicklung 1 keine Fehlstellen aufweist; b) Aufnehmen eines Referenzspannungsverlaufs 11, der den ersten Spannungspuls und den von Wicklung 1 zurückreflektierten ersten Spannungspuls aufweist, an dem ersten Ende 24 der Wicklung 1; f) Aufnehmen einer Mehrzahl an Referenzspannungsverläufen 11 durch Wiederholen der Schritte a) und b) bei verschiedenen ersten Zeitpunkten während dem Herstellen der Isolation einer elektrischen Maschine; c) Einspeisen eines zweiten Spannungspulses 2, bei dem schnell zwischen der Spannung U₀ und der Spannung U₁ umgeschaltet wird, in das erste Ende 24 der Wicklung 1; d) Aufnehmen eines Spannungsverlaufs 12, der den zweiten Spannungspuls 2 und den von der Wicklung 1 zurückreflektierten zweiten Spannungspuls 2 aufweist, an dem ersten Ende 24 der Wicklung 1; f) Aufnehmen einer Mehrzahl an Spannungsverläufen 12 durch Wiederholen der Schritte c) und d) bei verschiedenen zweiten Zeitpunkten während dem Herstellen der Isolation einer anderen elektrischen Maschine, wobei die zweiten Zeitpunkte derart gewählt werden, dass sie dem Herstellungsfortschritt der ersten Zeitpunkte entsprechen; e) Vergleichen der Spannungsverläufe 12 mit dem Referenzspannungsverläufen 11, die bei dem Herstellungsfortschritt entsprechenden ersten Zeitpunkten und zweiten Zeitpunkten aufgenommen wurden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Detektieren von Fehlstellen einer Wicklung (1) einer elektrischen Maschine, mit den Schritten:
a) Einspeisen eines ersten Spannungspulses (2), bei dem zwischen einer Spannung U₀ und einer Spannung U₁ umgeschaltet wird, in ein erstes Ende (24) der Wicklung (1);
b) Aufnehmen eines Referenzspannungsverlaufs (11), der den ersten Spannungspuls und den von Wicklung (1) zurückreflektierten ersten Spannungspuls aufweist, an dem ersten Ende (24) der Wicklung (1);
c) Einspeisen eines zweiten Spannungspulses (2), bei dem zwischen der Spannung U₀ und der Spannung U₁ umgeschaltet wird, in das erste Ende (24) der Wicklung (1);
d) Aufnehmen eines Spannungsverlaufs (12), der den zweiten Spannungspuls (2) und den von der Wicklung (1) zurückreflektierten zweiten Spannungspuls (2) aufweist, an dem ersten Ende (24) der Wicklung (1);
e) Vergleichen des Spannungsverlaufs (12) mit dem Referenzspannungsverlauf (11).

2. Verfahren gemäß Anspruch 1,
wobei mit einer Steilheit von 0,1 V bis 100 V pro Nanosekunde oder mit einer Steilheit von -0,1 bis -100 V pro Nanosekunde die Spannung umgeschaltet wird.

3. Verfahren gemäß Anspruch 1 oder 2,
wobei die Wicklung (1) eine Läuferwicklung ist und für den ersten Spannungspuls (2) und/oder den zweiten Spannungspuls (2) ein Umrichterimpuls einer die Läuferwicklung speisenden Erregereinrichtung eingesetzt wird.

4. Verfahren gemäß Anspruch 3,
wobei der Referenzspannungsverlauf (11) an der elektrischen Maschine zu einem Zeitpunkt durchgeführt wird, an dem die elektrische Maschine keine Fehlstellen aufweist.

5. Verfahren gemäß Anspruch 1 oder 2,
wobei die Wicklung (1) eine Ständerwicklung ist und das Verfahren während dem Herstellen der Isolation der Ständerwicklung durchgeführt wird.

6. Verfahren gemäß Anspruch 5, mit den Schritten:
f) Aufnehmen einer Mehrzahl an Referenzspannungsverläufen (11) durch Wiederholen der Schritte a) und b) bei verschiedenen ersten Zeitpunkten während dem Herstellen der Isolation einer elektrischen Maschine ohne Fehlstellen;
g) Aufnehmen einer Mehrzahl an Spannungsverläufen (12) durch Wiederholen der Schritte c) und d) bei verschiedenen zweiten Zeitpunkten während dem Herstellen der Isolation einer anderen elektrischen Maschine, wobei die zweiten Zeitpunkte derart gewählt werden, dass sie dem Herstellungsfortschritt der ersten Zeitpunkte entsprechen;
h) Wiederholen des Schritts e), wobei diejenigen Referenzspannungsverläufe (11) und Spannungsverläufe (12) miteinander verglichen werden, die bei dem Herstellungsfortschritt entsprechenden ersten und zweiten Zeitpunkten aufgenommen wurden.

7. Verfahren gemäß Anspruch 6, mit dem Schritt:
g1) Aufnehmen bei jedem der zweiten Zeitpunkte an einem zweiten Ende (25) der Läuferwicklung, das dem ersten Ende (24) gegenüberliegend angeordnet ist, jeweils eines Transmissionsspannungsverlaufs (13, 14), der den zweiten Spannungspuls (2) aufweist.

8. Verfahren gemäß Anspruch 7, mit dem Schritt:
g2) Vergleichen jeder der Transmissionsspannungsverläufe (14) mit dem frühesten Transmissionsspannungsverlauf (13).

9. Verfahren gemäß Anspruch 7 oder 8, mit dem Schritt:
i) Bestimmen einer Ausbreitungsgeschwindigkeit für mindestens einen der zweiten Spannungspulse (2) aus dem entsprechenden Transmissionsspannungsverlauf (13, 14) und der Länge der Läuferwicklung;
j) Bestimmen des Ortes einer Fehlstelle unter Heranziehen der Ausbreitungsgeschwindigkeit und des Vergleichs des Referenzspannungsverlaufs (11) mit dem Spannungsverlauf (12).
